(19) Europäisches Patentamt
European Patent Office
Office européen des brevets

(11) **EP 4 516 430 A1**

(12) **EUROPEAN PATENT APPLICATION**
published in accordance with Art. 153(4) EPC

(43) Date of publication:
**05.03.2025 Bulletin 2025/10**

(21) Application number: **23796402.8**

(22) Date of filing: **25.04.2023**

(51) International Patent Classification (IPC):
**B22F 9/24** (2006.01)     **B22F 1/00** (2022.01)
**B22F 1/0655** (2022.01)     **B22F 1/103** (2022.01)
**B22F 1/105** (2022.01)

(52) Cooperative Patent Classification (CPC):
**B22F 1/00; B22F 1/0655; B22F 1/103; B22F 1/105; B22F 9/24**

(86) International application number:
**PCT/JP2023/016354**

(87) International publication number:
**WO 2023/210662 (02.11.2023 Gazette 2023/44)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.04.2022 JP 2022075428**

(71) Applicant: DOWA Electronics Materials Co., Ltd.
**Tokyo 101-0021 (JP)**

(72) Inventors:
• **OSAKO Masaya**
**Tokyo 101-0021 (JP)**
• **NAKANOYA Taro**
**Tokyo 101-0021 (JP)**
• **TAKAHASHI Tetsu**
**Tokyo 101-0021 (JP)**

(74) Representative: **Müller-Boré & Partner Patentanwälte PartG mbB Friedenheimer Brücke 21 80639 München (DE)**

(54) **SPHERICAL SILVER POWDER, PRODUCTION METHOD FOR SPHERICAL SILVER POWDER, SPHERICAL SILVER POWDER PRODUCTION DEVICE, AND ELECTRICALLY CONDUCTIVE PASTE**

(57)     Provided is a spherical silver powder that can bring about excellent printability and low-temperature sintering ability when used in a conductive paste or the like. The spherical silver powder has a ratio of a diameter $D_{50}$ at a volume-based cumulative value of 50% according to laser diffraction relative to a BET diameter $D_{BET}$ of not less than 0.9 and not more than 1.2 and includes voids in inner parts of particles.

FIG. 1

**Description**

TECHNICAL FIELD

The present disclosure relates to a spherical silver powder, a method of producing a spherical silver powder, a spherical silver powder production apparatus, and a conductive paste.

BACKGROUND

Conductive pastes that are produced by kneading silver powder together with glass frit in an organic vehicle are used as conductive pastes for internal electrodes of multilayer capacitors, conductive patterns of circuit boards, solar cells, and various other electronic components. It is desirable for a silver powder used in such a conductive paste to have a suitably small particle diameter, uniform particle size, and high dispersibility in order to accommodate compactization of electronic components, densification of conductive patterns, fine line formation, and so forth.

As one example of a method of producing such a silver powder for a conductive paste, Patent Literature (PTL) 1 proposes a method of producing a fine particulate silver powder characterized by a silver nitrate aqueous solution and ammonia water being mixed and reacted to obtain a silver ammine complex aqueous solution, this aqueous solution being caused to flow in a certain channel (first channel), a second channel that converges with the first channel partway along the first channel being provided, an organic reductant being caused to flow through this second channel, and contacting and mixing being performed at a confluence point of the first channel and the second channel.

As another example, PTL 2 proposes a method of producing a silver powder by quantitatively and continuously supplying a silver complex-containing silver solution and a reductant solution into a channel and quantitatively and continuously reducing the silver complex in a reaction liquid obtained by mixing the silver solution and the reductant solution inside the channel to obtain a silver powder. A feature of this method of producing a silver powder is that relative to the flow velocity of the silver solution inside of a pipe forming the channel, a ratio of the flow velocity at which the reductant solution is supplied in the same direction as a supply direction of the silver solution from a pipe that is provided on the same axis in the pipe forming the channel is set as 1.5 or more during mixing of the silver solution and the reductant solution.

As another example, PTL 3 proposes a method of producing a spherical silver powder by mixing and reacting a silver nitrate aqueous solution and ammonia water to obtain a silver ammine complex aqueous solution, mixing the silver ammine complex aqueous solution and a reductant aqueous solution in the presence of particles serving as seeds and an imine compound, and thereby causing reduction precipitation of silver particles, wherein the silver ammine complex aqueous solution and the reductant aqueous solution are caused to flow in separate channels that converge at a confluence point, and the silver ammine complex aqueous solution and the reductant aqueous solution are brought into contact and mixed at the confluence point.

As yet another example, PTL 4 proposes a method of producing silver fine particles by adding ammonia and a reductant to a silver ion solution and causing reduction precipitation of silver fine particles, wherein the reductant is added within 20 seconds after ammonia addition so as to cause precipitation of minute silver fine particles. However, in this method, the silver ion solution to which ammonia is added and the reducing solution are mixed outside of a pipe path, and only a case in which hydroquinone solution is used as a reductant is disclosed as a specific example.

CITATION LIST

Patent Literature

PTL 1: JP2005-48236A
PTL 2: JP2015-45064A
PTL 3: JP2010-70793A
PTL 4: JP2008-255378A

SUMMARY

(Technical Problem)

In a situation in which a conductive paste that contains a silver powder is used to form an internal electrode, a conductive pattern, or the like, it has become desirable that the silver powder provides good printability as a conductive paste and also has excellent low-temperature sintering ability that enables sintering at low temperature (690°C to 740°C) in order to inhibit degradation of peripheral members caused by heating during firing of the conductive paste. Silver powders obtained by the production methods of PTL 1 to 4 leave room for improvement with regard to these points.

An object of the present disclosure is to provide a spherical silver powder that makes it possible to provide a conductive paste having excellent printability and low-temperature sintering ability and also to provide a production method and a production apparatus for this spherical silver powder.

(Solution to Problem)

The inventors conducted diligent studies to solve the problem set forth above and discovered that in order to simultaneously obtain both excellent low-temperature sintering ability and excellent printability, it is advantageous for voids to be present inside particles of a spherical silver powder and for dispersibility of such a spherical silver powder to be controlled through a ratio ($D_{50}/D_{BET}$) of a diameter $D_{50}$ at a volume-based cumulative value of 50% according to laser diffraction relative to a BET diameter $D_{BET}$. In this manner, the inventors completed the present disclosure. Silver powders obtained by the production methods of PTL 1 to 4 described above, for example, do not include voids inside particles.

The BET diameter $D_{BET}$ is a particle diameter that is calculated from the specific surface area SSA (units: $m^2/g$) measured by the BET single-point method and the true density (units: $g/cm^3$) and is determined by the following formula.

$$D_{BET} = 6/(SSA)/\text{True density}$$

$D_{50}$, $D_{BET}$, SSA, and true density are taken to be values measured by methods described in the EXAMPLES section.

A silver powder typically has a state in which the individual particles are not completely separated from one another and in which a plurality of particles are aggregated. Measurement of particle diameter by laser diffraction measures the particle diameter of particles in an aggregated state since the particle diameter is calculated from a diffraction pattern of particles. On the other hand, the BET single-point method measures the specific surface area using the amount of gas that is adsorbed by particles, and the BET diameter that is calculated from this specific surface area indicates the diameter of particles (particle diameter) when the measured particles are assumed to be perfect spheres. When the ratio ($D_{50}/D_{BET}$) is close to 1, this means that the silver powder has a state close to a monodisperse state with little aggregation.

A silver powder that includes voids inside of particles tends to have surface irregularities and makes it difficult to control the ratio ($D_{50}/D_{BET}$) to a value of close to 1.

The inventors discovered that by causing a silver-containing solution to flow in a channel, adding a complexing agent at a complexing agent addition position partway along the channel, adding formalin at a formalin addition position that is further downstream than the complexing agent addition position, and causing reduction precipitation of silver powder inside the channel, it is possible to obtain a spherical silver powder that includes voids inside of particles while also having a ratio ($D_{50}/D_{BET}$) of not less than 0.9 and not more than 1.2. In this manner, the inventors completed the present disclosure.

In a production method according to the present disclosure, a silver complex formation zone is created by causing a silver-containing solution to flow in a channel and adding a complexing agent into the channel at a complexing agent addition position partway along the channel and a silver powder reduction precipitation zone is created by adding formalin into the channel at a formalin addition position that is downstream of the complexing agent addition position. It is presumed that by continuously creating a silver complex formation zone and a reduction precipitation zone and by using formalin as a reductant in reduction precipitation in this manner, it is possible to obtain a spherical silver powder that includes voids in inner parts of particles while also having a ratio ($D_{50}/D_{BET}$) of not less than 0.9 and not more than 1.2 and having good dispersibility.

Primary features of the present disclosure are as follows.

[1] A spherical silver powder having a ratio of a diameter $D_{50}$ at a volume-based cumulative value of 50% according to laser diffraction relative to a BET diameter $D_{BET}$ of not less than 0.9 and not more than 1.2 and including voids in inner parts of particles.

[2] The spherical silver powder according to the foregoing [1], having a true density of not less than 9.0 $g/cm^3$ and not more than 10.0 $g/cm^3$.

[3] The spherical silver powder according to the foregoing [1] or [2], wherein the $D_{50}$ is not less than 0.2 $\mu$m and not more than 3.5 $\mu$m.

[4] The spherical silver powder according to any one of the foregoing [1] to [3], having a BET specific surface area of not less than 0.17 $m^2/g$ and not more than 3.23 $m^2/g$.

[5] The spherical silver powder according to any one of the foregoing [1] to [4], wherein a value obtained by subtracting content of carbon, nitrogen, and oxygen from ignition loss is less than 0.10 mass%.

[6] The spherical silver powder according to any one of the foregoing [1] to [5], wherein a ratio of oxygen content relative to carbon content is 1.5 or more.

[7] A method of producing a spherical silver powder comprising causing a silver-containing solution to flow in a channel, adding a complexing agent into the channel at a complexing agent addition position partway along the channel, adding formalin into the channel at a formalin addition position that is further downstream than the complexing agent addition position, and causing reduction precipitation of silver powder inside the channel.

[8] The method of producing a spherical silver powder according to the foregoing [7], wherein time required for the silver-containing solution to flow from the complexing agent addition position to the formalin addition position is not less than 0.1 seconds and not more than 10 seconds.

[9] The method of producing a spherical silver powder according to the foregoing [7] or [8], further comprising adding a surface treatment agent into the channel in-between the complexing agent addition position and the formalin addition position or at a downstream side of the formalin addition position.

[10] The method of producing a spherical silver powder according to any one of the foregoing [7] to [9], wherein addition of the formalin is performed from a plurality of directions at the formalin addition position, and each of the plurality of directions forms an angle of not less than 75° and not more than 105° relative to the channel.

[11] A spherical silver powder production apparatus that causes reduction precipitation of silver powder through addition of a complexing agent and formalin to a silver-containing solution, comprising: a pipe forming a channel for the silver-containing solution; a complexing agent addition section connected to the pipe; and a formalin addition section connected to the pipe at a downstream side of the complexing agent addition section.

[12] A conductive paste comprising: the spherical silver powder according to any one of the foregoing [1] to [6]; an organic binder; and a solvent.

[13] The conductive paste according to the foregoing [12] for formation of an electrode of a solar cell.

(Advantageous Effect)

According to the present disclosure, a spherical silver powder that can bring about excellent printability and low-temperature sintering ability when used in a conductive paste or the like is provided together with a production method and a production apparatus for this spherical silver powder.

BRIEF DESCRIPTION OF THE DRAWINGS

In the accompanying drawings:

FIG. 1 is an external perspective view of one example of a silver powder production apparatus according to the present disclosure;
FIG. 2 is an external perspective view of another example of a silver powder production apparatus according to the present disclosure;
FIG. 3A is an SEM photograph (×10,000) of a silver powder of Example 1 (before vacuum drying);
FIG. 3B is an SEM photograph (×10,000) of the silver powder of Example 1 (after vacuum drying and disintegration treatment);
FIG. 3C is an FE-SEM photograph (×20,000) of a cross-section of the silver powder of Example 1 (after vacuum drying and disintegration treatment);
FIG. 4A is an SEM photograph (×10,000) of a silver powder of Example 2 (before vacuum drying);
FIG. 4B is an SEM photograph (×10,000) of the silver powder of Example 2 (after vacuum drying and disintegration treatment);
FIG. 4C is an FE-SEM photograph (×20,000) of a cross-section of the silver powder of Example 2 (after vacuum drying and disintegration treatment);
FIG. 5A is an SEM photograph (×10,000) of a silver powder of Example 3 (before vacuum drying);
FIG. 5B is an SEM photograph (×10,000) of the silver powder of Example 3 (after vacuum drying and disintegration treatment);
FIG. 5C is an FE-SEM photograph (×20,000) of a cross-section of the silver powder of Example 3 (after vacuum drying and disintegration treatment);
FIG. 6A is an SEM photograph (×10,000) of a silver powder of Example 4 (before vacuum drying);
FIG. 6B is an SEM photograph (×10,000) of the silver powder of Example 4 (after vacuum drying and disintegration treatment);
FIG. 6C is an FE-SEM photograph (×20,000) of a cross-section of the silver powder of Example 4 (after vacuum drying and disintegration treatment);
FIG. 7A is an SEM photograph (×10,000) of a silver powder of Example 5 (before vacuum drying);

FIG. 7B is an SEM photograph (×10,000) of the silver powder of Example 5 (after vacuum drying and disintegration treatment);

FIG. 7C is an FE-SEM photograph (×20,000) of a cross-section of the silver powder of Example 5 (after vacuum drying and disintegration treatment);

FIG. 8A is an SEM photograph (×10,000) of a silver powder of Example 6 (before vacuum drying);

FIG. 8B is an SEM photograph (×10,000) of the silver powder of Example 6 (after vacuum drying and disintegration treatment);

FIG. 8C is an FE-SEM photograph (×20,000) of a cross-section of the silver powder of Example 6 (after vacuum drying and disintegration treatment);

FIG. 9A is an SEM photograph (×10,000) of a silver powder of Example 7 (before vacuum drying);

FIG. 9B is an SEM photograph (×10,000) of the silver powder of Example 7 (after vacuum drying and disintegration treatment);

FIG. 9C is an FE-SEM photograph (×20,000) of a cross-section of the silver powder of Example 7 (after vacuum drying and disintegration treatment);

FIG. 10A is an SEM photograph (×10,000) of a silver powder of Comparative Example 1 (before vacuum drying);

FIG. 10B is an SEM photograph (×10,000) of the silver powder of Comparative Example 1 (after vacuum drying and disintegration treatment);

FIG. 10C is an FE-SEM photograph (×20,000) of a cross-section of the silver powder of Comparative Example 1 (after vacuum drying and disintegration treatment);

FIG. 11A is an SEM photograph (×10,000) of a silver powder of Comparative Example 2 (before vacuum drying);

FIG. 11B is an SEM photograph (×10,000) of the silver powder of Comparative Example 2 (after vacuum drying and disintegration treatment);

FIG. 11C is an FE-SEM photograph (×20,000) of a cross-section of the silver powder of Comparative Example 2 (after vacuum drying and disintegration treatment);

FIG. 12 is a chart of thermal contraction rates in Example 1 and Comparative Examples 1 and 2;

FIG. 13 illustrates the shape of an electrode pattern for performing EL evaluation of fine line printability;

FIG. 14 is a photograph illustrating EL evaluation results for a conductive paste in which the silver powder of Example 1 was used;

FIG. 15 is a photograph illustrating EL evaluation results for a conductive paste in which the silver powder of Example 2 was used;

FIG. 16 is a photograph illustrating EL evaluation results for a conductive paste in which the silver powder of Example 3 was used;

FIG. 17 is a photograph illustrating EL evaluation results for a conductive paste in which the silver powder of Example 4 was used;

FIG. 18 is a photograph illustrating EL evaluation results for a conductive paste in which the silver powder of Example 5 was used;

FIG. 19 is a photograph illustrating EL evaluation results for a conductive paste in which the silver powder of Example 6 was used;

FIG. 20 is a photograph illustrating EL evaluation results for a conductive paste in which the silver powder of Comparative Example 1 was used; and

FIG. 21 is a photograph illustrating EL evaluation results for a conductive paste in which the silver powder of Comparative Example 2 was used.

DETAILED DESCRIPTION

<Spherical silver powder>

A spherical silver powder according to the present disclosure has a ratio ($D_{50}/D_{BET}$) of a diameter $D_{50}$ at a volume-based cumulative value of 50% according to laser diffraction relative to a BET diameter $D_{BET}$ of not less than 0.9 and not more than 1.2 and includes voids in inner parts of particles.

The term "spherical" encompasses roughly spherical shapes and is taken to mean a shape having an average aspect ratio (average ratio of major axis/minor axis) of 1.5 or less. The voids in inner parts of particles are closed voids that are not externally connected.

It is possible to confirm that a spherical silver powder includes voids in inner parts of particles by observing particle cross-sections using a field emission scanning electron microscope (FE-SEM) and confirming the presence of voids in inner parts of the particles.

The ratio ($D_{50}/D_{BET}$) is preferably 1.20 or less, more preferably 1.15 or less, and even more preferably 1.04 or less from a viewpoint of obtaining excellent dispersibility. This ratio is normally 0.90 or more, and is more preferably set as 0.95 or more.

$D_{50}$ is preferably 0.2 μm or more, and more preferably 0.5 μm or more from a viewpoint of ease of paste handling when the spherical silver powder is used as a conductive paste. Moreover, $D_{50}$ is preferably 3.5 μm or less, and more preferably 3.0 μm or less from a viewpoint that suitable particle activity is obtained, being advantageous in terms of low-temperature sintering ability of a wiring pattern formed using a conductive paste, and also from a viewpoint of ease of accommodating densification, etc.

The diameter $D_{10}$ at a volume-based cumulative value of 10% for the spherical silver powder according to the present disclosure is preferably 0.1 μm or more, and is preferably 2.0 μm or less.

The diameter $D_{90}$ at a volume-based cumulative value of 90% for the spherical silver powder according to the present disclosure is preferably 0.5 μm or more, and is preferably 7.0 μm or less

$D_{10}$ and $D_{90}$ are taken to be values measured by a method described in the EXAMPLES section.

The BET specific surface area (SSA) is preferably 0.17 $m^2$/g or more, and more preferably 0.20 $m^2$/g or more from a viewpoint that suitable particle activity is obtained, being advantageous in terms of low-temperature sintering ability of a wiring pattern formed using a conductive paste, and also from a viewpoint of ease of accommodating densification, etc. Moreover, the BET specific surface area (SSA) is preferably 3.23 $m^2$/g or less, and more preferably 2.40 $m^2$/g or less from a viewpoint of ease of paste handling when the spherical silver powder is used as a conductive paste.

Although the true density of silver is 10.49 g/$cm^3$, the spherical silver powder according to the present disclosure can have a true density of not less than 9.0 g/$cm^3$ and not more than 10.0 g/$cm^3$ as a result of including voids in inner parts of particles. The true density is preferably 9.4 g/$cm^3$ or more from a viewpoint of ease of accommodating densification of a wiring pattern, etc., and is preferably 9.9 g/$cm^3$ or less from a viewpoint of low-temperature sintering ability.

$D_{BET}$ is the BET diameter (μm) that is calculated by the following formula using the specific surface area ($m^2$/g) measured by the BET single-point method and the true density (g/$cm^3$).

$$\text{BET diameter} = 6/\text{Specific surface area}/\text{True density}$$

$D_{BET}$ is preferably 0.18 μm or more, and more preferably 0.45 μm or more, and is preferably 3.90 μm or less, and more preferably 3.20 μm or less.

The tap density of the spherical silver powder according to the present disclosure is preferably 2.5 g/$cm^3$ or more, and more preferably 4.5 g/$cm^3$ or more from a viewpoint of ease of accommodating high-accuracy patterning, etc. On the other hand, the upper limit for the tap density is 7.8 g/$cm^3$ when the true density of silver and densest packing of a uniform spherical powder are taken into account.

The ignition loss of the spherical silver powder according to the present disclosure is preferably 2.65 mass% or less, and more preferably 1.62 mass% or less. Measurement conditions of the ignition loss are as described in the EXAMPLES section.

The spherical silver powder according to the present disclosure preferably has a carbon content of 1.00 mass% or less, and more preferably 0.50 mass% or less, preferably has a nitrogen content of 0.15 mass% or less, and more preferably 0.12 mass% or less, and preferably has an oxygen content of 1.50 mass% or less, and more preferably 1.00 mass% or less. The oxygen content is preferably 0.20 mass% or more, and more preferably 0.30 mass% or more from a viewpoint of low-temperature sintering ability. The contents of carbon, nitrogen, and oxygen are taken to be values measured by methods in the EXAMPLES section.

A ratio O/C of the oxygen content relative to the carbon content is preferably 1.5 or more, is preferably 3.5 or less, and is more preferably not less than 1.7 and not more than 3.0 from a viewpoint of low-temperature sintering ability. Particularly in a case in which the spherical silver powder according to the present disclosure is used in a conductive paste in which glass frit is compounded, oxygen contained inside silver particles assists heat generation, and thus can promote softening of the glass, and is advantageous in terms of low-temperature firing.

Moreover, a value obtained by subtracting the total content of carbon, nitrogen, and oxygen from the ignition loss of the spherical silver powder according to the present disclosure is preferably less than 0.10 mass%, and more preferably 0.09 mass% or less. When the value is within any of these ranges, it is easy to avoid a problem of thermal expansion in a situation in which the spherical silver powder according to the present disclosure is used to form a component such as an electrode, for example.

<Method of producing spherical silver powder>

A method of producing a spherical silver powder according to the present disclosure includes causing a silver-containing solution to flow in a channel, adding a complexing agent at a complexing agent addition position partway along the channel, adding formalin at a formalin addition position that is further downstream than the complexing agent addition position, and causing reduction precipitation of silver powder inside the channel. By continuously supplying a silver-containing solution, a complexing agent, and formalin and performing quantitative mixing thereof in the production method according to the present disclosure, it is possible to maintain the rate of silver complex formation and the rate of reduction precipitation of silver powder as fixed rates and to quantitatively and continuously obtain a specific spherical silver powder.

The silver-containing solution is a solution that reacts with the complexing agent to form a silver complex and can be a solution that contains a silver salt. For example, the silver-containing solution may be an aqueous solution of silver nitrate, silver chloride, silver formate, silver oxalate, silver sulfate, or the like, and is preferably a silver nitrate aqueous solution from viewpoints such as ease of acquisition.

The silver concentration of the silver-containing solution is preferably 0.01 mol/L or more, and more preferably 0.05 mol/L or more from a financial viewpoint. The silver concentration is preferably 0.5 mol/L or less, and more preferably 0.3 mol/L or less from a viewpoint of ensuring interparticle distance of particles after reduction precipitation and inhibiting aggregation.

The flow velocity of the silver-containing solution is preferably 0.45 m/s or more, and more preferably 0.65 m/s or more from a viewpoint of productivity and forming monodisperse particles, and is preferably 3.20 m/s or less, and more preferably 2.70 m/s or less from a viewpoint of inhibiting aggregation and forming monodisperse particles.

In the production method according to the present disclosure, the silver-containing solution is caused to flow in the channel, and the complexing agent is added at the complexing agent addition position partway along the channel to thereby form a silver complex.

The complexing agent may be ammonia, an ammonium salt, citric acid, acetic acid, or the like, of which, ammonia is preferable. The ammonia can be added in the form of ammonia water.

For example, in a case in which ammonia water is added as the complexing agent, a silver ammine complex is formed. A silver ammine complex is preferable because it can easily be reduced by formalin. The additive amount of ammonia water is preferably an amount such that silver ions that have not formed the silver ammine complex do not substantially remain in the liquid, can be set as an amount such that ammonia is not less than 2.6 moles and not more than 11.2 moles relative to 1 mole of silver, and is preferably an amount such that ammonia is not less than 3.1 moles and not more than 10.4 moles relative to 1 mole of silver.

From a financial viewpoint, the concentration of the ammonia water is preferably 3.1 mol/L or more, and more preferably 3.7 mol/L or more, and is preferably 16.2 mol/L or less, and more preferably 15.1 mol/L or less.

The flow velocity of the ammonia water is preferably 0.40 m/s or more, and more preferably 0.60 m/s or more, and is preferably 3.20 m/s or less, and more preferably 2.70 m/s or less.

Even in a case in which another complexing agent is used, the concentration and flow velocity can be set in accordance with the above description.

In the production method according to the present disclosure, formalin is added into the channel at the formalin addition position that is further downstream than the complexing agent addition position, thereby causing reduction precipitation of silver powder. By using formalin as a reductant, it is possible to obtain a silver powder including voids in inner parts of particles.

The concentration of the formalin (formaldehyde aqueous solution) is preferably 3.9 mol/L or more, and more preferably 4.7 mol/L or more, and is preferably 14.5 mol/L or less, and more preferably 12.8 mol/L or less.

The amount of formalin is preferably an amount such that unreacted silver ions are not substantially produced, can be set as an amount such that formalin (formaldehyde) is not less than 3.1 moles and not more than 10.6 moles relative to 1 mole of silver, and is preferably an amount such that formalin (formaldehyde) is not less than 3.7 moles and not more than 9.3 moles relative to 1 mole of silver.

In the production method according to the present disclosure, the time required (elapsed time) for the silver-containing solution to flow from the complexing agent addition position to the formalin addition position is preferably 0.1 seconds or more, and more preferably 0.5 seconds or more in order that the formalin is added once a silver complex solution has been formed. Moreover, the elapsed time is preferably 10.0 seconds or less, and more preferably 5.0 seconds or less in order that a reaction between the complexing agent and a substance other than silver ions is not initiated because reaction of the complexing agent with a substance other than silver ions may result in increased silver complex stability and lower tendency for a reduction reaction to progress. A long elapsed time of more than 10.0 seconds is thought to result in a change of formation of by-products between addition of the complexing agent and addition of the formalin and during the reduction reaction and in an increase of the value obtained by subtracting the total content of carbon, nitrogen, and oxygen from the ignition loss. This is also thought to result in a decrease of the ratio of oxygen content relative to carbon content inside the silver particles.

In the production method according to the present disclosure, a surface treatment agent can be added into the channel in-between the complexing agent addition position and the formalin addition position or at a downstream side of the formalin addition position. The addition of a surface treatment agent is advantageous in terms of inhibiting aggregation of silver powder that has undergone reduction precipitation. The addition is preferably performed at a point between the complexing agent addition position and the formalin addition position.

The surface treatment agent may be a fatty acid, a fatty acid salt, a surfactant, an organometallic, a chelating agent, a protective colloid, or the like. The surface treatment agent can be used in an amount such as to be not less than 0.03 mass% and not more than 1.00 mass% relative to silver in the silver-containing solution. The surface treatment agent may be used in the form of an emulsion, a solution, or the like.

(1) Fatty acid

The fatty acid may be propionic acid, caprylic acid, lauric acid, myristic acid, palmitic acid, stearic acid, behenic acid, acrylic acid, oleic acid, linoleic acid, arachidonic acid, ricinoleic acid, or the like.

(2) Fatty acid salt

The fatty acid salt may be a metal salt of any of the fatty acids described above in (1), where the metal may be lithium, sodium, potassium, barium, magnesium, calcium, aluminum, iron, cobalt, manganese, lead, zinc, tin, strontium, zirconium, silver, copper, or the like.

(3) Surfactant

The surfactant may be an anionic surfactant such as an alkylbenzenesulfonic acid salt or a polyoxyethylene alkyl ether phosphoric acid salt, a cationic surfactant such as an aliphatic quaternary ammonium salt, an amphoteric surfactant such as an imidazolinium betaine, or a non-ionic surfactant such as a polyoxyethylene alkyl ether or a polyoxyethylene fatty acid ester.

(4) Organometallic

The organometallic may be acetylacetone tributoxyzirconium, magnesium citrate, diethylzinc, dibutyltin oxide, dimethylzinc, tetra-n-butoxyzirconium, triethylindium, triethylgallium, trimethylindium, trimethylgallium, monobutyltin oxide, tetraisocyanatosilane, tetramethylsilane, tetramethoxysilane, monomethyltriisocyanatosilane, a silane coupling agent, a titanate-based coupling agent, an aluminum-based coupling agent, or the like.

(5) Chelating agent

The chelating agent may be imidazole, oxazole, thiazole, selenazole, pyrazole, isoxazole, isothiazole, 1H-1,2,3-triazole, 2H-1,2,3-triazole, 1H-1,2,4-triazole, 4H-1,2,4-triazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 1H-1,2,3,4-tetrazole, 1,2,3,4-oxatriazole, 1,2,3,4-thiatriazole, 2H-1,2,3,4-tetrazole, 1,2,3,5-oxatriazole, 1,2,3,5-thiatriazole, indazole, benzimidazole, benzotriazole, or the like; a salt of any of these chelating agents; a dicarboxylic acid such as succinic acid, malonic acid, glutaric acid, or adipic acid or another such polycarboxylic acid; or the like.

(6) Protective colloid

The protective colloid may be a peptide, gelatin, albumin, gum Arabic, protalbic acid, lysalbic acid, glue, or the like.

The surface treatment agent is preferably the (1) fatty acid from a viewpoint of ease of modification of the surfaces of silver particles. In particular, stearic acid is preferable. The (1) fatty acid is preferably in the form of an emulsion. For example, a stearic acid emulsion or the like may be used.

In the production method according to the present disclosure, the temperature of liquid flowing in the channel is preferably 5°C or higher, and more preferably 15°C or higher from a viewpoint of reactivity in the reduction reaction, and is preferably 60°C or lower, and more preferably 50°C or lower from an operational viewpoint.

In the production method according to the present disclosure, a mixer may be used to impart spiral rotation in an axial direction of the channel so as to perform liquid mixing.

A spherical silver powder can be obtained in the production method according to the present disclosure by discharging a liquid containing silver powder that has undergone reduction precipitation (hereinafter, also referred to as a "silver powder-containing liquid") to outside of the channel and collecting the liquid. The time from addition of formalin to discharge of the silver powder-containing liquid to outside of the channel is preferably 1 second or more, and more preferably 2 seconds or more from a viewpoint that completion of the reduction reaction can be expected, and is preferably 10 seconds or less, and more preferably 5 seconds or less from a viewpoint of inhibiting settling in piping.

As a result of formalin being added into the channel at the formalin addition position that is further downstream than the complexing agent addition position in the production method according to the present disclosure, a reduction reaction occurs to form silver nuclei inside the channel, and these silver nuclei undergo particle growth to form silver particles inside the channel. Since the instigation of a reduction reaction outside of a channel as in PTL 4 may result in increased surface irregularities, it is preferable that a reduction reaction and particle growth are caused to occur inside a channel as in the production method according to the present disclosure.

The shape of the silver powder can be controlled by controlling the flow velocity after formalin addition. For example, setting the flow velocity after formalin addition as a slower velocity than the flow velocity of the silver complex solution before addition is advantageous for reducing aggregation of the silver powder.

The silver powder-containing liquid that has been discharged to outside of the channel is subjected to filtration and water washing to obtain a lumpy cake that contains the silver powder and water and that has almost no fluidity.

This cake is dried by a dryer such as a forced circulation air dryer, a vacuum dryer, or a pneumatic conveying dryer to yield the spherical silver powder according to the present disclosure. Substitution of water in the cake with a lower alcohol or the like enables quic/ker drying.

The cake can be subjected to dry disintegration treatment, surface smoothing treatment, or the like. The surface smoothing treatment can be performed by causing particles to mechanically collide with one another using a high-speed stirrer.

Classification treatment may subsequently be performed in order to remove aggregates of the silver powder that are larger than a specific particle diameter.

Moreover, drying, grinding, and classification may be performed with respect to the cake using an integrated apparatus that is capable of performing drying, disintegration, and classification (for example, a DRYMEISTER or MICRON DRYER produced by Hosokawa Micron Corporation).

<Silver powder production apparatus>

In the production method according to the present disclosure, it is possible to use a spherical silver powder production apparatus that includes a pipe forming a channel for a silver-containing solution, a complexing agent addition section connected to the pipe, and a formalin addition section connected to the pipe at a downstream side of the complexing agent addition section. No specific limitations are placed on the structure of the complexing agent addition section and the formalin addition section.

The complexing agent addition section and the formalin addition section may each be a Y-shaped pipe path or a T-shaped pipe path, or may have a structure in which a second pipe is connected partway along the pipe forming the channel for the silver-containing solution and in which the channel for the silver-containing solution and a channel of the second pipe converge.

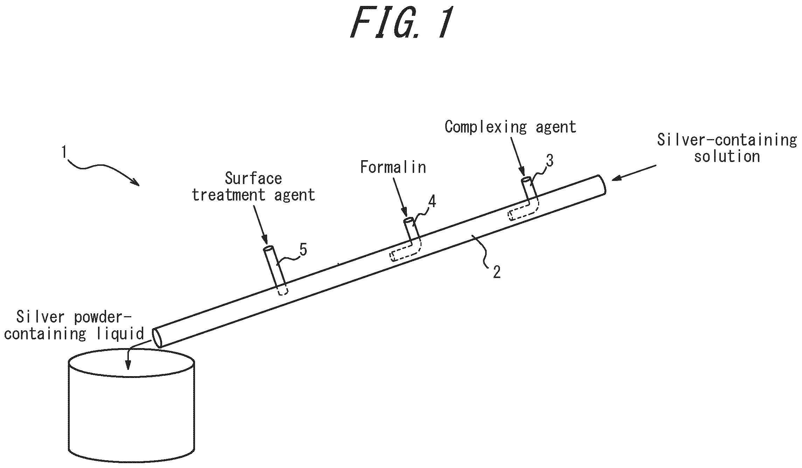

Alternatively, the complexing agent addition section and the formalin addition section may each be a coaxial double pipe path. FIG. 1 is a schematic view of an example of the silver powder production apparatus in which the complexing agent addition section and the formalin addition section are each a coaxial double pipe path.

In FIG. 1, a silver powder production apparatus 1 includes a pipe 2 along which a silver-containing solution flows, a complexing agent supply pipe 3 that supplies a complexing agent, and a formalin supply pipe 4 that supplies formalin. The pipe 2 is formed with a linear shape, and the complexing agent supply pipe 3 and the formalin supply pipe 4 are each formed with a roughly L shape. In the silver powder production apparatus 1, the complexing agent supply pipe 3 is disposed such that one side of the L shape of the complexing agent supply pipe 3 is coaxial with the pipe 2 inside of the pipe 2, and the formalin supply pipe 4 is disposed such that one side of the L shape of the formalin supply pipe 4 is coaxial with the pipe 2 inside of the pipe 2 at a downstream side of the section where the complexing agent supply pipe 3 is disposed. The complexing agent and formalin are supplied toward a downstream side in the channel of the pipe 2 from the complexing agent supply pipe 3 and the formalin supply pipe 4, respectively. The silver powder production apparatus 1 includes a surface treatment agent supply pipe 5 for supplying a surface treatment agent at a downstream side of the section of the pipe 2 where the formalin supply pipe 4 is disposed. The surface treatment agent supply pipe 5 for supplying the surface treatment agent may alternatively be disposed at an upstream side of the section where the formalin supply pipe 4 is disposed. For example, the surface treatment agent supply pipe 5 can be disposed between the complexing agent supply pipe 3 and the formalin supply pipe 4.

The silver powder production apparatus may have a structure in which the pipe along which the silver-containing solution flows is a pipe in which a slit with an opening facing in an outward radial direction along an inner perimeter of the pipe is provided and in which a formalin supply pipe for supplying formalin is connected to the slit. The number of formalin supply pipes is preferably at least two or more. By using an apparatus having such a structure, it is possible to cause the formalin to enter the pipe from the slit roughly perpendicularly (for example, at not less than 75° and not more than 105°) from the entire outer perimeter of the pipe.

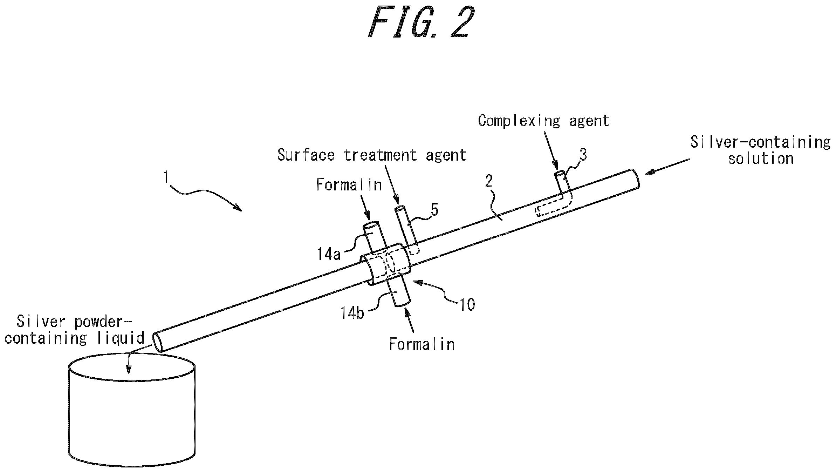

FIG. 2 is a schematic view of one example of a silver powder production apparatus that includes a formalin addition section that supplies formalin into a pipe from a slit.

In FIG. 2, a silver powder production apparatus 1 includes a pipe 2 along which a silver-containing solution flows, a complexing agent supply pipe 3 that supplies a complexing agent, and a formalin addition member 10 that supplies formalin. The formalin addition member 10 has formalin supply pipes 14a and 14b eccentrically connected thereto. Formalin that is supplied from the formalin supply pipes 14a and 14b enters the pipe 2 along the entire outer perimeter thereof from a slit that is provided in the pipe 2. The silver powder production apparatus 1 in FIG. 2 includes a surface treatment agent supply pipe 5 for supplying a surface treatment agent at an upstream side of the formalin addition member 10 in the pipe 2, though the surface treatment agent supply pipe 5 may alternatively be disposed at a downstream side thereof.

<Conductive paste>

The spherical silver powder according to the present disclosure can provide a conductive paste having excellent printability and low-temperature sintering ability and is suitable for a conductive paste that is used for internal electrodes of multilayer capacitors, conductive patterns of circuit boards, electrodes and circuits of solar cells and various other electronic components, and so forth.

A conductive paste according to the present disclosure can contain the spherical silver powder according to the present disclosure, an organic binder, and a solvent.

The organic binder may be silicone resin, epoxy resin, acrylic resin, polyester resin, polyimide resin, polyurethane resin, phenoxy resin, cellulosic resin (ethyl cellulose, hydroxypropyl cellulose, etc.), or the like, for example, without any specific limitations. One of these organic binders may be used individually, or two or more of these organic binders may be used in combination in a freely selected ratio.

The solvent may be an alcohol solvent such as terpineol, butyl carbitol, texanol, ethylene glycol, diethylene glycol, or glycerin; an ester solvent such as butyl carbitol acetate or ethyl acetate; a hydrocarbon solvent such as toluene, xylene, or cyclohexane; or the like, for example, without any specific limitations. One of these solvents may be used individually, or two or more of these solvents may be used in combination in a freely selected ratio.

The content of the spherical silver powder according to the present disclosure in the conductive paste can be set as 80 mass% or more, and is preferably 85 mass% or more. Moreover, the content of the spherical silver powder according to the present disclosure in the conductive paste can be set as 95 mass% or less, and is preferably 90 mass% or less.

The content of the organic binder in the conductive paste can be set as 0.1 mass% or more, and is preferably 0.2 mass% or more. Moreover, the content of the organic binder in the conductive paste can be set as 0.4 mass% or less, and is preferably 0.3 mass% or less.

The content of the solvent in the conductive paste can be set as 6 mass% or more, and is preferably 7 mass% or more. Moreover, the content of the solvent in the conductive paste can be set as 20 mass% or less, and is preferably 15 mass% or less.

The conductive paste can contain glass frit, a dispersant, a surfactant, a viscosity modifier, a slip agent, and so forth as optional components. In a case in which the conductive paste is used in production of an electrode of a solar cell, it is preferable that the conductive paste contains glass frit. The glass frit may be glass frit based on Pb-Te-Bi, Pb-Si-B, or the like.

The production method of the conductive paste is not specifically limited and may be a method in which the spherical silver powder according to the present disclosure, the organic binder, the solvent, and, in some cases, optional components are mixed. The method of mixing is not specifically limited and can be performed using a planetary stirrer, an ultrasonic disperser, a disper, a three-roll mill, a ball mill, a bead mill, a twin-screw kneader, or the like.

The conductive paste according to the present disclosure can be applied onto a substrate to form a coating film by dipping, printing such as screen printing, offset printing, or photolithography, or the like, for example. The coating film may be provided with a specific patterned shape through photolithography using a resist, for example.

The coating film can be fired to form a conductive film. The firing may be performed in an air atmosphere or may be performed in a non-oxidizing atmosphere such as nitrogen.

The spherical silver powder according to the present disclosure has excellent low-temperature sintering ability and makes it possible to set the firing temperature of the coating film as not lower than 600°C and not higher than 800°C, and preferably as not lower than 690°C and not higher than 760°C. The firing time can be set as not less than 20 seconds and not more than 1 hour, is preferably 40 seconds or more, and is preferably 20 minutes or less, and more preferably 2 minutes or less.

The conductive paste according to the present disclosure can suitably be used for formation of internal electrodes of multilayer capacitors, conductive patterns of circuit boards, and electrodes and circuits of solar cells and various other electronic components.

EXAMPLES

The following describes examples according to the present disclosure. However, the present disclosure is not limited by these examples.

[Evaluation of silver powder]

Silver powders of examples and comparative examples were evaluated as follows.

<True density>

True density was measured by a fixed-volume expansion method ("Gas pycnometer method" in Japanese Pharmacopoeia) using a dry-type automatic density meter (produced by Micromeritics Instrument Corporation; instrument name: AccuPyc II 1340). Measurement of true density is performed in a manner such that closed voids in inner parts of silver particles that are not externally connected are included in the density.

<BET specific surface area>

BET specific surface area was measured using a fully automated specific surface area measurement instrument (produced by Mountech Co., Ltd.; instrument name: Macsorb HM-model 1210). A silver powder was loaded into the instrument, deaeration was performed through ventilation with He-$N_2$ mixed gas (30% nitrogen) at 60°C for 10 minutes, and measurement was subsequently performed by the BET single-point method.

<$D_{10}$, $D_{50}$, and $D_{90}$>

$D_{10}$, $D_{50}$, and $D_{90}$ were determined by laser diffraction wet sample measurement using a Microtrac particle size distribution measurement instrument (produced by MicrotracBEL Corp.; instrument name: MT-3300EXII). In this measurement, 0.1 g of a sample (silver powder) was added to and dispersed in 40 mL of isopropyl alcohol (IPA). Dispersing was performed using an ultrasonic homogenizer (produced by NIHONSEIKI KAISHA LTD.; instrument name: US-150T; 19.5 kHz; tip diameter: 18 mm). The dispersing time was set as 2 minutes. The dispersed sample was supplied into the above-described instrument, and a particle size distribution was determined by analysis software accompanying the instrument.

<Ignition loss (Ig-Loss) of silver powder>

Ignition loss was determined by weighing out 2 g of a sample (silver powder), loading the sample into a magnetic crucible, performing intense heating at 800°C for 30 minutes, which is sufficient time for a constant quantity to be reached, subsequently cooling the sample, weighing the sample to determine the mass (w) after heating, and calculating the ignition loss (%) by the following formula.

$$\text{Ignition loss (\%)} = (2 - \text{w})/2 \times 100$$

Unidentified content was taken to be a value determined by subtracting, from the ignition loss, measured values of the contents of carbon, nitrogen, and oxygen, which were obtained through measurement by measurement methods in the following "Contents of carbon, nitrogen, and oxygen" section.

<Contents of carbon, nitrogen, and oxygen>

The contents of carbon, nitrogen, and oxygen were measured as follows.
The content of carbon was determined by using a carbon/sulfur analyzer (produced by Horiba, Ltd.; instrument name: EMIA-810) to heat and melt a sample (silver powder) at 1350°C in a stream of oxygen, measure CO and $CO_2$ produced during this heating and melting by infrared absorption, and converting the measured value to a content of carbon. The amount of the sample (silver powder) that was used in the measurement was taken to be an amount falling within a range of a calibration curve upon comparison of intensity with a standard sample by preliminary measurement.
The content of nitrogen was determined by using a simultaneous oxygen/nitrogen/hydrogen analyzer (produced by LECO Corporation; instrument name: ONH836) to measure the nitrogen content in 0.20 g of a sample (silver powder) by thermal conduction in a helium or argon atmosphere with an impulse furnace power value of 4,000 W.
The content of oxygen was determined by using a simultaneous oxygen/nitrogen/hydrogen analyzer (produced by LECO Corporation; instrument name: ONH836) to measure the oxygen content in 0.05 g of a sample (silver powder) by infrared absorption in a helium or argon atmosphere with an impulse furnace power value of 4,000 W.

<Tap density>

The tap density (TAP) was taken to be a value determined using a tap density measurement instrument (produced by Shibayama Scientific Co., Ltd.; instrument name: Bulk specific gravity measurement instrument SS-DA-2). Measurement of tap density was performed as follows. After weighing out 30 g of a silver powder and loading this silver powder into a 20 mL test tube, the test tube was subject to tapping 1,000 times with a drop of 20 mm. The sample volume ($cm^3$) after tapping was determined. The tap density ($g/cm^3$) was determined by the following formula.

$$\text{Tap density } (g/cm^3) = 30 \ (g)/\text{Sample volume after tapping } (cm^3)$$

[Production of silver powder]

Silver powders of examples and comparative examples were produced as follows.

<Example 1>

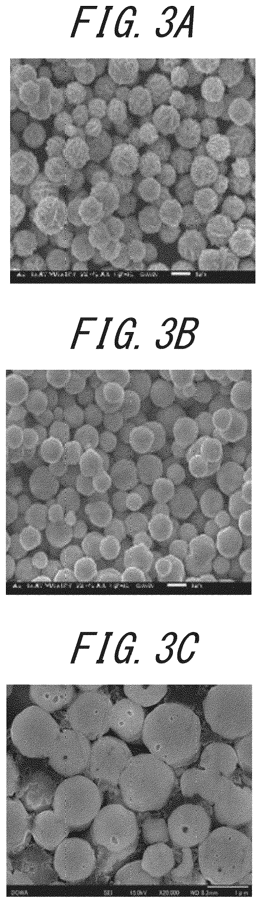

A silver powder was produced using the apparatus illustrated in FIG. 1.
A silver nitrate aqueous solution having a silver concentration of 0.13 mol/L was introduced into a pipe 2 (internal diameter: 20 mm) at a flow rate of 21.5 L/min with a liquid temperature of 25.7°C, and from approximately 1 second thereafter, a 9.4 mass% ammonia aqueous solution was introduced at a flow rate of 2.3 L/min from a complexing agent supply pipe 3 (internal diameter: 6 mm) that was a coaxial double pipe so as to produce a silver ammine complex inside the pipe 2. The amount of the silver nitrate aqueous solution is an amount that results in a silver concentration of 0.1 mol/L in the total amount of liquid after addition of the complexing agent, formalin, and a surface treatment agent.
Approximately 2.23 seconds after addition of the ammonia aqueous solution, formalin (17.4 mass% formaldehyde aqueous solution) was introduced at a flow rate of 2.5 L/min from a formalin supply pipe 4 (internal diameter: 6 mm; external diameter: 8 mm) that was a coaxial double pipe so as to cause precipitation of silver powder. The flow velocity of the silver complex solution prior to formalin addition at a point directly before the formalin addition position was 1.50 m/s, and the flow velocity of formalin was 1.50 m/s.
Approximately 1 second after addition of the formalin, a surface treatment agent (0.17 mass% Selosol aqueous solution; Selosol 920 (produced by Chukyo Yushi Co., Ltd.; containing 15.5 mass% of stearic acid)) was introduced at a flow rate of 2.5 L/min from a surface treatment agent supply pipe 5. The additive amount (target value) of stearic acid is an amount such that stearic acid is 0.18 mass% relative to silver. In this manner, a silver powder-containing slurry was obtained. In the above, the distance from the ammonia aqueous solution addition position to the formalin addition position was set as 1.8 m, and the distance from the formalin addition position to the surface treatment agent addition position was set as 1.6 m.
The silver powder-containing slurry was discharged from the pipe 2. The obtained silver powder-containing slurry was subjected to solid-liquid separation, and the resultant solid material was washed with pure water so as to remove impurities in the solid material. The end point of this washing can be judged from the electrical conductivity of water after washing. The washing was performed until this electrical conductivity was 0.5 mS/m or less, and then the solid material was dried and subsequently disintegrated to yield 310 g of a silver powder. The time from addition of the surface treatment agent until discharge was 1 second to 2 seconds. Other production conditions and evaluation results are shown in Tables 1 and 2.
SEM photographs (×10,000) of the silver powder of Example 1 are presented in FIG. 3A (before vacuum drying) and FIG. 3B (after vacuum drying and disintegration treatment). Moreover, FIG. 3C presents a field emission scanning electron microscope (FE-SEM) photograph (×20,000) of particle cross-sections of the silver powder (after vacuum drying and disintegration treatment). It can be seen from FIG. 3C that voids are present in inner parts of particles.

<Example 2>

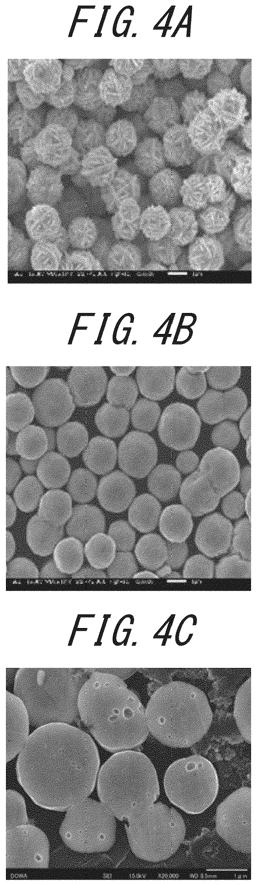

In production of a silver powder of Example 2, the installation position of the surface treatment agent supply pipe 5 was changed such that the surface treatment agent supply pipe 5 was installed between the complexing agent supply pipe 3 and the formalin supply pipe 4, and thus the surface treatment agent was added before formalin addition. The distance from the surface treatment agent addition position (before formalin addition) to the formalin addition position was set as 17.5 cm. The silver powder of Example 2 was produced in the same way as in Example 1 with other production conditions set as shown in Table 1. The evaluation results are shown in Table 2.
SEM photographs (×10,000) of the silver powder of Example 2 are presented in FIG. 4A (before vacuum drying) and FIG. 4B (after vacuum drying and disintegration treatment). Moreover, FIG. 4C presents an FE-SEM photograph (×20,000) of particle cross-sections of the silver powder of Example 2 (after vacuum drying and disintegration treatment). It can be seen from FIG. 4C that voids are present in inner parts of particles.

<Examples 3 to 6>

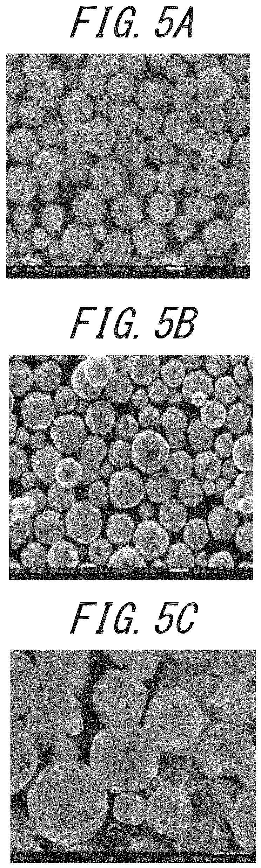

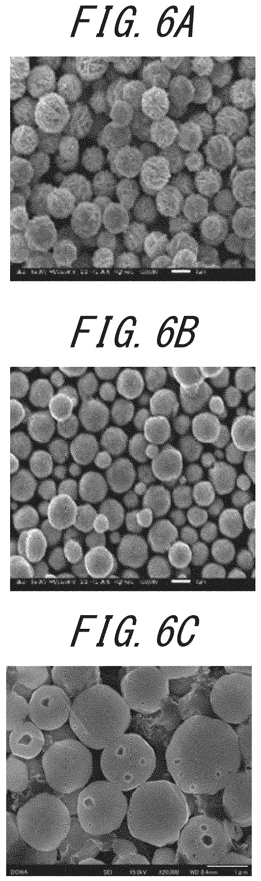

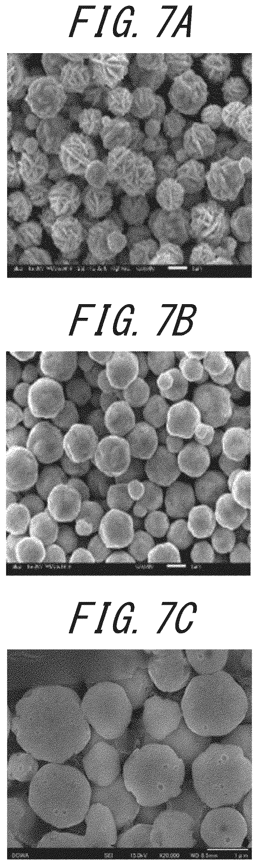

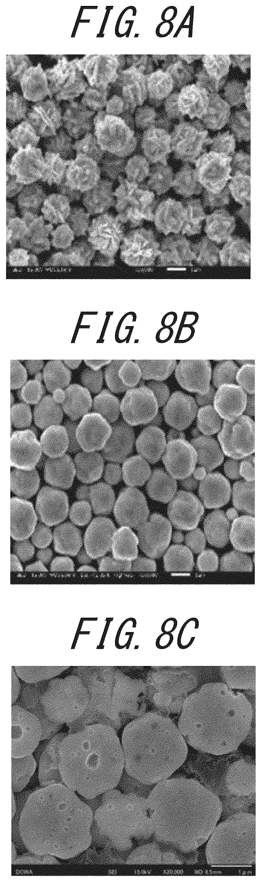

Production of silver powders of Examples 3 to 6 was performed using the silver powder production apparatus illustrated in FIG. 2. Using an apparatus including a formalin addition member 10 (denoted as a "slit" in Table 1) that was provided with a slit (slit width: 0.44 mm) having an opening facing in an outward radial direction along an inner perimeter of a pipe 2 (pipe internal diameter: 20.6 mm) and having formalin supply pipes 14a and 14b eccentrically connected to the slit, formalin was added into the pipe 2 from the entire perimeter of the pipe 2. A surface treatment agent supply pipe 5 was installed between the formalin addition member 10 and a complexing agent supply pipe 3 so as to add a surface treatment agent before formalin addition. In the formalin addition member 10 of Example 5, a pipe 2 having a pipe internal diameter of 21.4 mm was used. In Examples 5 and 6, a mixer that imparted rotation to flow was disposed at the introduction position of silver nitrate aqueous solution so as to perform liquid mixing. Note that the distance from the ammonia aqueous solution addition position to the formalin addition position was set as 2.1 m, and the distance from the surface treatment agent addition position (before formalin addition) to the formalin addition position was set as 17.5 cm. The silver powders of Examples 3 to 6 were produced in the same way as in Example 1 with other production conditions set as shown in Table 1. The evaluation results are shown in Table 2.
SEM photographs (×10,000) of the silver powders of Examples 3 to 6 are presented in FIGS. 5A to 8A (before vacuum drying) and FIGS. 5B to 8B (after vacuum drying and disintegration treatment). Moreover, FIGS. 5C to 8C present FE-SEM photographs (×20,000) of particle cross-sections of the silver powders of Examples 3 to 6 (after vacuum drying and disintegration treatment). It can be seen from FIGS. 5C to 8C that voids are present in inner parts of particles in the silver powders of Examples 3 to 6.

<Example 7>

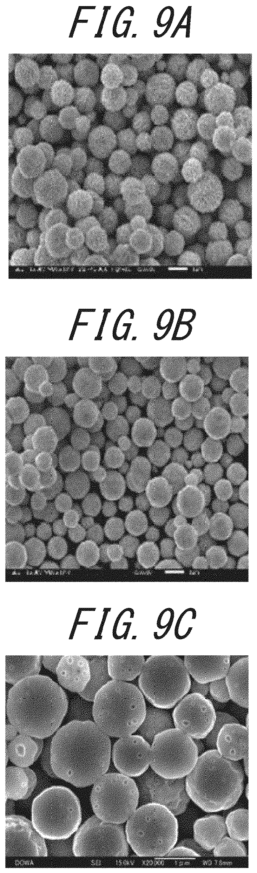

A silver powder of Example 7 was produced in the same way as in Example 1 with the exception that production conditions were changed as shown in Table 1. The evaluation results are shown in Table 2. SEM photographs (×10,000) of the silver powder of Example 7 are presented in FIG. 9A (before vacuum drying) and FIG. 9B (after vacuum drying and disintegration treatment). Moreover, FIG. 9C presents an FE-SEM photograph (×20,000) of particle cross-sections of the silver powder of Example 7 (after vacuum drying and disintegration treatment). It can be seen from FIG. 9C that voids are present in inner parts of particles.

<Comparative Example 1>

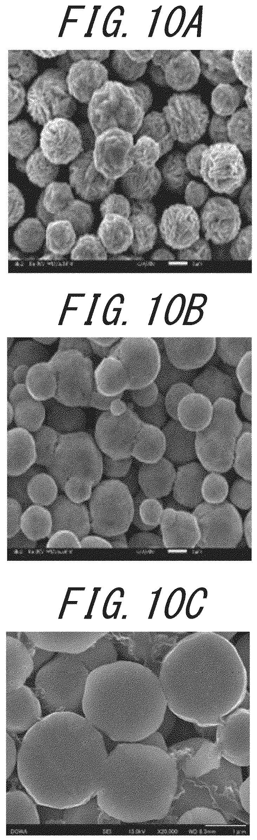

Production of a silver powder of Comparative Example 1 was performed using the silver powder production apparatus illustrated in FIG. 1 (however, a complexing agent supply pipe 3 was not included). A silver nitrate aqueous solution and an ammonia aqueous solution were pre-mixed in a tank (not illustrated) to prepare a silver ammine complex aqueous solution with a silver concentration of 0.12 mol/L and an ammonia concentration of 0.51 mol/L. Approximately 5 minutes after preparation, the silver ammine complex aqueous solution was introduced into a pipe (internal diameter: 20 mm) of the silver powder production apparatus in FIG. 1 (not including a complexing agent supply pipe 3) at a flow rate of 25.6 L/min with a liquid temperature of 30.4°C instead of a silver-containing solution.
Approximately 4 seconds after introduction of the silver ammine complex aqueous solution, formalin (18.5 mass% aqueous solution) was introduced at a flow rate of 2.5 L/min from an inner pipe (internal diameter: 6 mm; external diameter: 8 mm) of a coaxial double pipe so as to cause precipitation of silver powder.
Next, a surface treatment agent (0.17 mass% Selosol aqueous solution; Selosol 920 (produced by Chukyo Yushi Co., Ltd.; containing 15.5 mass% of stearic acid)) was supplied from a supply pipe (inner pipe: 6 mm) connected to the pipe.
A silver-containing slurry was discharged from the pipe and was treated in the same way as in Example 1. Other production conditions and evaluation results are shown in Tables 1 and 2. SEM photographs (×10,000) of the silver powder of Comparative Example 1 are presented in FIG. 10A (before vacuum drying) and FIG. 10B (after vacuum drying and disintegration treatment). Moreover, FIG. 10C presents an FE-SEM photograph (×20,000) of particle cross-sections of the silver powder of Comparative Example 1 (after vacuum drying and disintegration treatment).

<Comparative Example 2>

A silver powder of Comparative Example 2 was produced in the same way as in Comparative Example 1 with the exception that the surface treatment agent was added before formalin addition. The evaluation results are shown in Table 2.

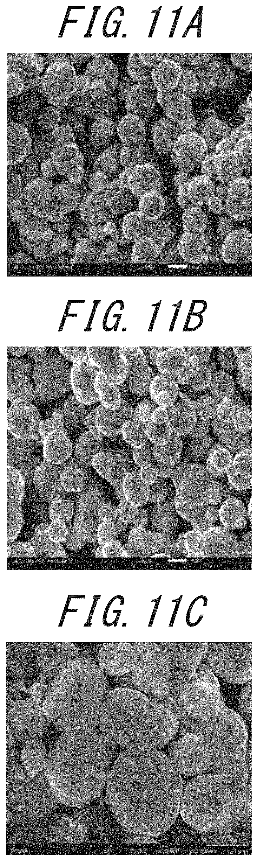

SEM photographs (×10,000) of the silver powder of Comparative Example 2 are presented in FIG. 11A (before vacuum drying) and FIG. 11B (after vacuum drying and disintegration treatment). Moreover, FIG. 11C presents an FE-SEM photograph (×20,000) of particle cross-sections of the silver powder of Comparative Example 2 (after vacuum drying and disintegration treatment).

[Table 1]

| | Silver complex formation method | Time from complexing agent mixing to formalin addition | Formalin addition method | Surface treatment agent addition position | Mixer | Silver concentration* [mol/L] | NH$_3$ equivalents | HCHO equivalents | Additive amount of treatment agent [mass%]** | Silver nitrate solution temperature [°C] | Complex temperature [°C] | Silver complex flow velocity before reductant addition [m/s] | Reductant flow velocity [m/s] | Flow velocity after reduction [m/s] |
|---|---|---|---|---|---|---|---|---|---|---|---|---|---|---|
| Comparative Example 1 | Pre-mixing | 5 min | Coaxial double pipe | Post-addition | No | 0.1 | 2.14 | 10.9 | 0.18 | - | 30.4 | 1.61 | 1.50 | 1.30 |
| Comparative Example 2 | Pre-mixing | 5 min | Coaxial double pipe | Pre-addition | No | 0.1 | 2.14 | 10.9 | 0.18 | - | 29.0 | 1.61 | 1.50 | 1.30 |
| Example 1 | In-pipe mixing | 2.23 sec | Coaxial double pipe | Post-addition | No | 0.1 | 2.14 | 10.9 | 0.18 | 25.7 | 26.8 | 1.50 | 1.50 | 1.39 |
| Example 2 | In-pipe mixing | 2.48 sec | Coaxial double pipe | Pre-addition | No | 0.1 | 2.35 | 9.2 | 0.18 | 19.3 | 21.0 | 1.63 | 1.50 | 1.50 |
| Example 3 | In-pipe mixing | 2.12 sec | Slit | Pre-addition | No | 0.1 | 2.14 | 10.9 | 0.18 | 22.1 | 27.8 | 1.50 | 1.49 | 1.51 |
| Example 4 | In-pipe mixing | 1.82 sec | Slit | Pre-addition | No | 0.1 | 2.57 | 11.4 | 0.18 | 30.4 | 30.4 | 1.75 | 1.74 | 1.76 |
| Example 5 | In-pipe mixing | 1.59 sec | Slit | Pre-addition | Yes | 0.05 | 2.35 | 11.4 | 0.18 | 29.0 | 29.5 | 2.00 | 1.99 | 2.01 |
| Example 6 | In-pipe mixing | 1.82 sec | Slit | Pre-addition | Yes | 0.05 | 2.35 | 11.4 | 0.18 | 29.1 | 29.0 | 1.75 | 1.74 | 1.76 |
| Example 7 | In-pipe mixing | 1.33 sec | Coaxial double pipe | Post-addition | No | 0.1 | 2.60 | 12.4 | 0.39 | 25.8 | Not measured | 1.62 | 1.47 | 1.49 |

* Silver concentration in total amount of liquid after addition of complexing agent, formalin, and surface treatment agent ** Additive amount (target value) of stearic acid relative to silver

[Table 2]

| | True density [g/cm³] | BET specific surface area [m²/g] | $D_{10}$ [μm] | $D_{50}$ [μm] | $D_{90}$ [μm] | $D_{BET}$ [μm] | $D_{50}/D_{BET}$ | Ig-loss [mass%] | Tap density [g/cm³] | C content [mass%] | N content [mass%] | O content [mass%] | Unidentified components* [mass%] | Ratio (O/C) of O content relative to C content |
|---|---|---|---|---|---|---|---|---|---|---|---|---|---|---|
| Comparative Example 1 | 9.8 | 0.3 | 1.64 | 2.97 | 6.09 | 2.37 | 1.25 | 0.75 | 5.8 | 0.24 | 0.07 | 0.34 | 0.10 | 1.4 |
| Comparative Example 2 | 9.8 | 0.3 | 1.22 | 2.71 | 5.61 | 1.88 | 1.44 | 0.91 | 5.5 | 0.30 | 0.10 | 0.41 | 0.10 | 1.4 |
| Example 1 | 9.6 | 0.4 | 0.97 | 1.59 | 2.89 | 1.43 | 1.11 | 0.83 | 5.6 | 0.23 | 0.07 | 0.45 | 0.08 | 2.0 |
| Example 2 | 9.7 | 0.3 | 1.47 | 2.45 | 5.53 | 2.24 | 1.09 | 0.70 | 5.8 | 0.21 | 0.06 | 0.40 | 0.03 | 1.9 |
| Example 3 | 9.8 | 0.3 | 1.20 | 1.77 | 2.75 | 1.80 | 0.99 | 0.75 | 5.8 | 0.21 | 0.06 | 0.41 | 0.07 | 2.0 |
| Example 4 | 9.7 | 0.4 | 1.07 | 1.61 | 2.60 | 1.61 | 1.00 | 0.77 | 5.9 | 0.21 | 0.07 | 0.43 | 0.06 | 2.0 |
| Example 5 | 9.8 | 0.4 | 1.21 | 1.81 | 2.91 | 1.73 | 1.04 | 0.63 | 5.8 | 0.18 | 0.04 | 0.35 | 0.06 | 1.9 |
| Example 6 | 9.7 | 0.4 | 1.30 | 1.88 | 2.92 | 1.70 | 1.11 | 0.61 | 5.2 | 0.18 | 0.04 | 0.34 | 0.05 | 1.9 |
| Example 7 | 9.4 | 0.5 | 0.93 | 1.36 | 2.05 | 1.33 | 1.02 | 1.17 | 4.7 | 0.42 | 0.08 | 0.64 | 0.03 | 1.5 |

* Value determined by subtracting C, N, and O content from Ig-loss

[Thermomechanical analysis (TMA)]

The silver powders of the examples and comparative examples were each used to produce a pellet having a roughly cylindrical shape (diameter: 5 mm) through application of a load of 50 kgf for 1 minute by a pellet forming machine. This pellet was then set in a thermomechanical analysis (TMA) instrument (produced by Rigaku Corporation; instrument name: TMA8311) and was heated from normal temperature to 900°C with a heating rate of 10°C/min in an air atmosphere. The length a of the pellet at normal temperature and the length b of the pellet during maximum contraction were used to calculate a thermal contraction rate by the following formula from the reduction c of pellet length relative to the difference (a - b). Temperatures resulting in thermal contraction rates of 10%, 20%, 50%, and 90% were determined, and thermal expansion was evaluated.

$$\text{Thermal contraction rate} = c \times 100/(a - b)$$

Table 3 shows the temperatures resulting in thermal contraction rates of 10%, 20%, 50%, and 90% for the silver powders of Examples 1 to 4, Examples 6 and 7, and Comparative Examples 1 and 2.

[Table 3]

| | | | | | | | | (°C) |
|---|---|---|---|---|---|---|---|---|
| | Comparative Example 1 | Comparative Example 2 | Example 1 | Example 2 | Example 3 | Example 4 | Example 6 | Example 7 |
| 10% contraction temperature | 418 | 415 | 350 | 399 | 367 | 363 | 378 | 317 |
| 20% contraction temperature | 444 | 435 | 387 | 428 | 398 | 395 | 409 | 354 |
| 50% contraction temperature | 506 | 489 | 455 | 489 | 461 | 457 | 469 | 429 |
| 90% contraction temperature | 624 | 597 | 552 | 591 | 555 | 551 | 568 | 529 |

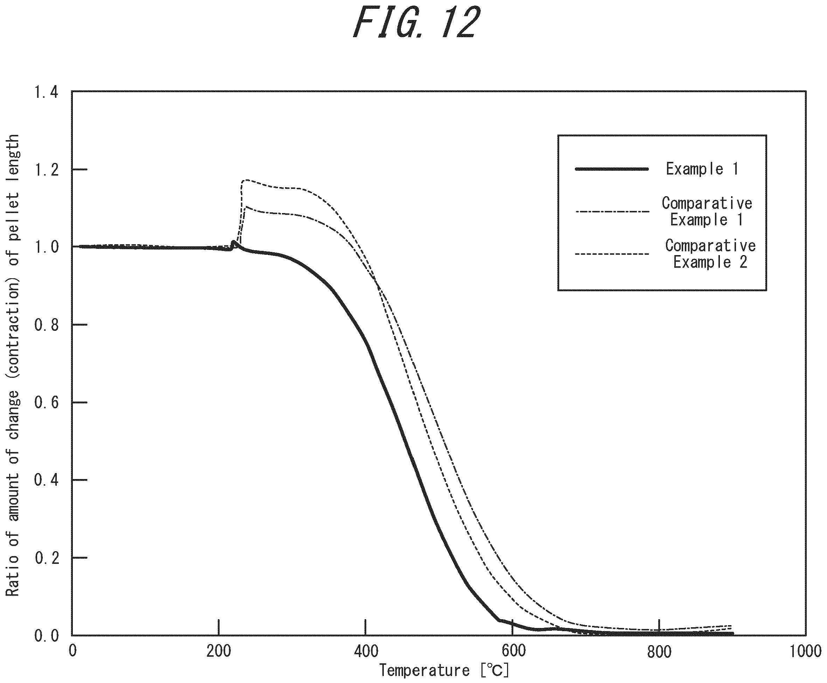

FIG. 12 illustrates a chart of measurement results for thermal contraction rates in Example 1 and Comparative Examples 1 and 2. The vertical axis of the chart is a ratio of the amount of change (contraction) of the length of the pellet relative to the difference between the length of the pellet at normal temperature and the length of the pellet during maximum contraction.

[Production of conductive paste]

The silver powders of Examples 1 to 6 and Comparative Examples 1 and 2 were each used to produce a conductive paste as follows.

The silver powder of each example or comparative example was used to obtain a conductive paste by performing the following treatment with respect to substances shown below in Table 4 in the composition ratio shown in Table 4. The substances were stirred and mixed at 1,400 rpm for 30 seconds using a propeller-less planetary stirring and defoaming device (AR310 produced by Thinky Corporation) and were subsequently kneaded by a three-roll mill (80S produced by Exakt Technologies Inc.) through passing with a roll gap of from 100 μm to 20 μm.

[Table 4]

| | Mass% |
|---|---|
| Ethyl cellulose | 0.10 |
| Hydroxypropyl cellulose | 0.10 |
| Wax* | 0.07 |

(continued)

|  | Mass% |
|---|---|
| Triethylene glycol butyl methyl ether | 1.83 |
| Terpineol | 1.20 |
| Texanol | 1.28 |
| Butyl carbitol acetate | 1.18 |
| Tributyl citrate | 1.34 |
| Dimethyl polysiloxane 100 cs** | 0.40 |
| Triethanolamine | 0.26 |
| Castor oil | 0.07 |
| Oleic acid | 0.69 |
| Pb-Te-Bi-based glass frit | 1.99 |
| Silver powder of example/comparative example | 89.48 |
| Total | 100.00 |
| * NAMLON206T produced by Kusumoto Chemicals, Ltd.<br>** KF96-100 produced by Shin-Etsu Chemical Co., Ltd. | |

[Evaluation of printability (fine line printability)]

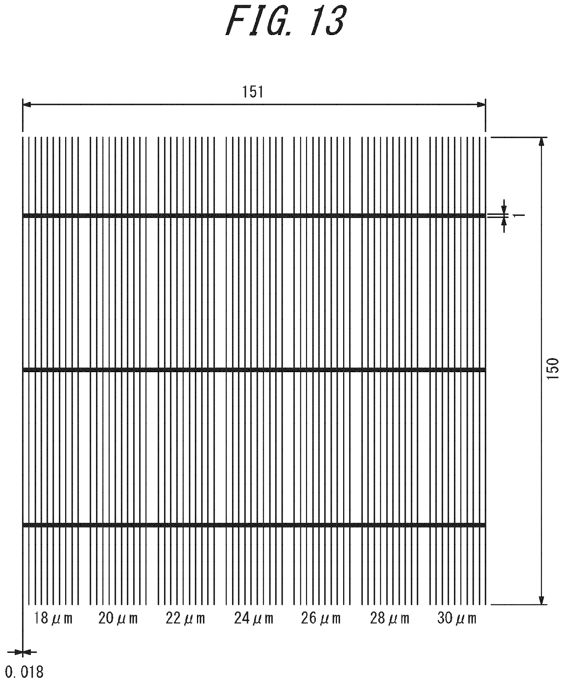

Fine line evaluation (EL) was performed by forming and evaluating a conductive pattern. Formation of the conductive pattern was performed as follows. First, an aluminum paste (28D22G-2 produced by Rutech) was used to form a 154 mm solid pattern on a rear surface of a silicon substrate (100 $\Omega$/sq.) for a solar cell using a screen printer (MT-320TV produced by Micro-tec Co., Ltd.). Next, the above-described conductive paste produced using the silver powder of each example or comparative example was filtered at 500-mesh and was subsequently used to print (apply) electrodes (finger electrodes) with line widths of 14 $\mu$m to 26 $\mu$m and electrodes (busbar electrodes) with a width of 1 mm at a squeegee speed of 350 mm/sec in a pattern illustrated in FIG. 13 at a front surface side of the substrate. After performing 10 minutes of hot-air drying at 200°C, a high-speed firing IR furnace (high-speed firing test four-chamber furnace produced by NGK Insulators, Ltd.) was used to perform firing with a peak temperature of 750°C and an in-out time of 41 seconds to obtain a conductive pattern.

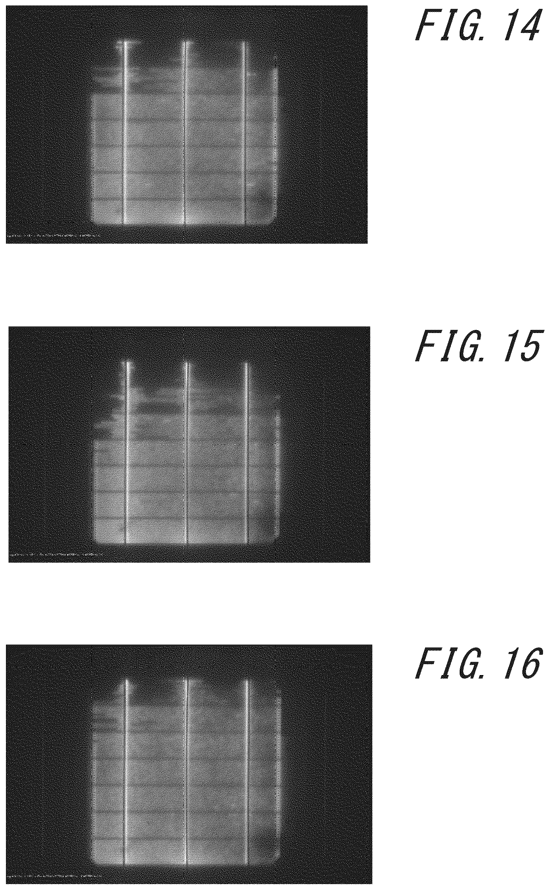

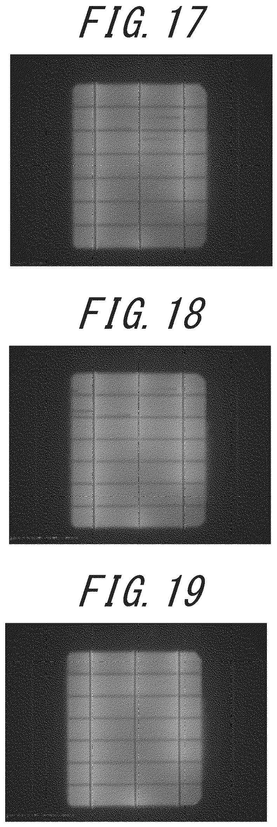

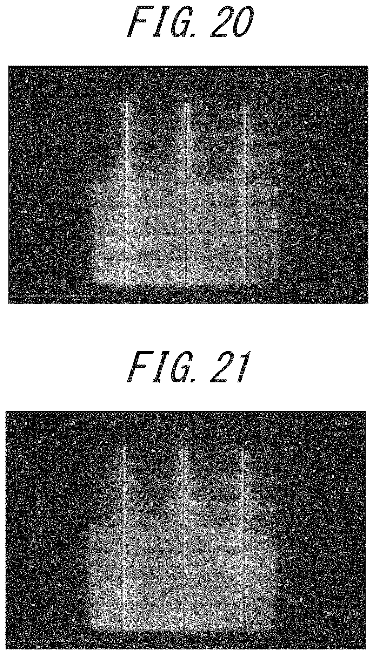

After the conductive pattern had been obtained, an EL/PL evaluation instrument (PVX330+POPLI-3C produced by ITES Co., Ltd.) was used to confirm the presence or absence of electrode disconnection. Note that in this EL/PL evaluation instrument, current was caused to flow in the busbar electrodes, and EL (electroluminescence) evaluation was performed. In a case in which there is disconnection of an electrode (finger electrode) between busbar electrodes, the position where there is disconnection appears black because light is not emitted. FIGS. 14 to 21 illustrate EL evaluation results for conductive pastes in which the silver powders of Examples 1 to 6 and Comparative Examples 1 and 2 were used. It can be seen that with the conductive pastes in which the silver powders of the comparative examples were used, more black sections where light was not emitted were observed due to disconnection at thinner line widths, whereas the conductive pastes in which the silver powders of the examples were used enabled fine line printing to a greater extent. It can also be seen that the examples resulted in light emission at thinner line width with less disconnection and enabled fine line printing even when the peak temperature during firing was set as 690°C or 710°C.

[Measurement of volume resistivity]

Production of a conductive film and measurement of volume resistivity were performed for the conductive pastes in which the silver powders of Examples 1 to 6 and Comparative Examples 1 and 2 were used. Production of a conductive film was performed as follows.

A sample for volume resistivity evaluation was produced through screen printing of the conductive paste. An MT-320 produced by Micro-tec Co., Ltd. was used as a printer, and a mask produced by Murakami Co., Ltd. (250-mesh; emulsion thickness: 10 $\mu$m) that had a zig-zag design with a line width of 0.5 mm and a length of 128 mm was also used. During printing, the squeegee speed was set as 40 mm/s and the printing pressure was set as 0.18 MPa. The printing subject was taken to be a Si substrate for a solar cell that had been processed to 1 inch-square.

The printed sample was loaded into a hot-air dryer (LC-114 produced by ESPEC CORP.) that was set to 200°C and was left at rest for 5 minutes to dry the sample. After drying, firing was performed in a high-speed firing test furnace (solar cell firing furnace produced by NGK Insulators, Ltd.) set such that the peak temperature of the 1 inch substrate was 690°C, 710°C, or 740°C to obtain a conductive film.

Evaluation of volume resistivity was performed by measuring the line resistance of the obtained conductive film using a digital multimeter (7451A produced by Advantest Corporation), measuring an average value of the cross-sectional area of the conductive film using a laser microscope (VK-X1000 produced by Keyence Corporation), multiplying the line resistance ($\Omega$) by the average value of the cross-sectional area, and dividing the resultant value by the length of the conductive film to determine the volume resistivity ($\mu\Omega \cdot cm$). The results are shown in Table 5.

[Table 5]

| | | | | | | | | ($\mu\Omega$ cm) |
|---|---|---|---|---|---|---|---|---|
| | Comparative Example 1 | Comparative Example 2 | Example 1 | Example 2 | Example 3 | Example 4 | Example 5 | Example 6 |
| 740°C firing | 4.85 | 4.20 | 3.23 | 3.23 | 3.49 | 3.37 | 2.72 | 3.61 |
| 710°C firing | 4.67 | 4.10 | 3.17 | 3.17 | 3.37 | 2.46 | 3.58 | 3.52 |
| 690°C firing | 4.49 | 3.83 | 3.01 | 3.01 | 3.20 | 3.04 | 3.24 | 3.36 |

It can be seen that the examples result in lower volume resistivity for the conductive films produced at each of the firing temperatures and that the conductive pastes in which the silver powders of the examples were used have excellent low-temperature sintering ability.

INDUSTRIAL APPLICABILITY

According to the present disclosure, a spherical silver powder that can bring about excellent printability and low-temperature sintering ability when used in a conductive paste or the like is provided together with a production method and a production apparatus for this spherical silver powder.

REFERENCE SIGNS LIST

1       silver powder production apparatus
2       pipe
3       complexing agent supply pipe
4       formalin supply pipe
5       surface treatment agent supply pipe
10     formalin addition member
14a    formalin supply pipe
14b    formalin supply pipe

**Claims**

1.   A spherical silver powder having a ratio ($D_{50}/D_{BET}$2. of a diameter $D_{50}$ at a volume-based cumulative value of 50% according to laser diffraction relative to a BET diameter $D_{BET}$ of not less than 0.9 and not more than 1.2 and including voids in inner parts of particles.

2.   The spherical silver powder according to claim 1, having a true density of not less than 9.0 g/cm$^3$ and not more than 10.0 g/cm$^3$.

3.   The spherical silver powder according to claim 1, wherein the $D_{50}$ is not less than 0.2 $\mu$m and not more than 3.5 $\mu$m.

4. The spherical silver powder according to claim 1, having a BET specific surface area of not less than 0.17 m$^2$/g and not more than 3.23 m$^2$/g.

5. The spherical silver powder according to claim 1, wherein a value obtained by subtracting content of carbon, nitrogen, and oxygen from ignition loss is less than 0.10 mass%.

6. The spherical silver powder according to claim 1, wherein a ratio of oxygen content relative to carbon content is 1.5 or more.

7. A method of producing a spherical silver powder comprising causing a silver-containing solution to flow in a channel, adding a complexing agent into the channel at a complexing agent addition position partway along the channel, adding formalin into the channel at a formalin addition position that is further downstream than the complexing agent addition position, and causing reduction precipitation of silver powder inside the channel.

8. The method of producing a spherical silver powder according to claim 7, wherein time required for the silver-containing solution to flow from the complexing agent addition position to the formalin addition position is not less than 0.1 seconds and not more than 10 seconds.

9. The method of producing a spherical silver powder according to claim 7, further comprising adding a surface treatment agent into the channel in-between the complexing agent addition position and the formalin addition position or at a downstream side of the formalin addition position.

10. The method of producing a spherical silver powder according to any one of claims 7 to 9, wherein addition of the formalin is performed from a plurality of directions at the formalin addition position, and each of the plurality of directions forms an angle of not less than 75° and not more than 105° relative to the channel.

11. A spherical silver powder production apparatus that causes reduction precipitation of silver powder through addition of a complexing agent and formalin to a silver-containing solution, comprising: a pipe forming a channel for the silver-containing solution; a complexing agent addition section connected to the pipe; and a formalin addition section connected to the pipe at a downstream side of the complexing agent addition section.

12. A conductive paste comprising: the spherical silver powder according to any one of claims 1 to 6; an organic binder; and a solvent.

13. The conductive paste according to claim 12 for formation of an electrode of a solar cell.

# FIG. 1

Silver-containing solution

Complexing agent — 3

Formalin — 4

Surface treatment agent — 5

1

2

Silver powder-containing liquid

## FIG. 2

## FIG. 3A

## FIG. 3B

## FIG. 3C

*FIG. 4A*

*FIG. 4B*

*FIG. 4C*

## FIG. 5A

## FIG. 5B

## FIG. 5C

## FIG. 6A

## FIG. 6B

## FIG. 6C

*FIG. 7A*

*FIG. 7B*

*FIG. 7C*

*FIG. 8A*

*FIG. 8B*

*FIG. 8C*

## FIG. 9A

## FIG. 9B

## FIG. 9C

## FIG. 10A

## FIG. 10B

## FIG. 10C

*FIG. 11A*

*FIG. 11B*

*FIG. 11C*

# FIG. 12

FIG. 13

*FIG. 14*

*FIG. 15*

*FIG. 16*

## FIG. 17

## FIG. 18

## FIG. 19

*FIG. 20*

*FIG. 21*

## INTERNATIONAL SEARCH REPORT

| | International application No. |
|---|---|
| | **PCT/JP2023/016354** |

### A. CLASSIFICATION OF SUBJECT MATTER

*B22F 9/24*(2006.01)i; *B22F 1/00*(2022.01)i; *B22F 1/0655*(2022.01)i; *B22F 1/103*(2022.01)i; *B22F 1/105*(2022.01)i
FI:   B22F9/24 E; B22F1/00 K; B22F1/0655; B22F1/103; B22F1/105

According to International Patent Classification (IPC) or to both national classification and IPC

### B. FIELDS SEARCHED

Minimum documentation searched (classification system followed by classification symbols)
B22F9/24; B22F1/00; B22F1/0655; B22F1/103; B22F1/105

Documentation searched other than minimum documentation to the extent that such documents are included in the fields searched
Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | US 2022/0055941 A1 (DAEJOO ELECTRONIC MATERIALS CO., LTD.) 24 February 2022 (2022-02-24)<br>abstract, paragraphs [0001], [0057], [0117]-[0139], [0145]-[0178], fig. 1-2 | 1-4, 12-13 |
| Y | | 5-6, 12-13 |
| Y | JP 2012-214873 A (DAEJOO ELECTRONIC MATERIALS CO., LTD.) 08 November 2012 (2012-11-08)<br>paragraphs [0027]-[0030] | 5, 12-13 |
| Y | JP 2017-206763 A (DAEJOO ELECTRONIC MATERIALS CO., LTD.) 24 November 2017 (2017-11-24)<br>paragraph [0037] | 6, 12-13 |
| Y | JP 2008-255378 A (MITSUBISHI MATERIALS CORP) 23 October 2008 (2008-10-23)<br>paragraphs [0002]-[0011], [0016]-[0019], fig. 1 | 7-11 |
| Y | JP 2013-189704 A (DAEJOO ELECTRONIC MATERIALS CO., LTD.) 26 September 2013 (2013-09-26)<br>paragraphs [0001]-[0012], [0016]-[0017], [0019], [0028]-[0070], fig. 1-3 | 7-11 |

☑ Further documents are listed in the continuation of Box C.   ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **26 June 2023** | **11 July 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

| International application No. |
|---|
| **PCT/JP2023/016354** |

**C.    DOCUMENTS CONSIDERED TO BE RELEVANT**

| Category* | Citation of document, with indication, where appropriate, of the relevant passages | Relevant to claim No. |
|---|---|---|
| Y | JP 2020-56050 A (DAEJOO ELECTRONIC MATERIALS CO., LTD.) 09 April 2020 (2020-04-09)<br>    paragraphs [0001]-[0007], [0028]-[0030], [0037]-[0072], fig. 1-8 | 7-11 |
| Y | JP 2011-42839 A (DAEJOO ELECTRONIC MATERIALS CO., LTD.) 03 March 2011 (2011-03-03)<br>    claims 1-3, paragraphs [0026], [0032], fig. 2, 9, 11, 24 | 10 |
| A | WO 2019/117234 A1 (DAEJOO ELECTRONIC MATERIALS CO., LTD.) 20 June 2019 (2019-06-20)<br>    entire text, all drawings | 1-13 |
| A | WO 2018/142943 A1 (M TECHNIQUE CO., LTD.) 09 August 2018 (2018-08-09)<br>    entire text, all drawings | 1-13 |

Form PCT/ISA/210 (second sheet) (January 2015)

## INTERNATIONAL SEARCH REPORT
### Information on patent family members

International application No.

**PCT/JP2023/016354**

| Patent document cited in search report | | | Publication date (day/month/year) | Patent family member(s) | | | Publication date (day/month/year) |
|---|---|---|---|---|---|---|---|
| US | 2022/0055941 | A1 | 24 February 2022 | WO | 2020/204450 | A1 | |
| | | | | KR | 10-2020-0114890 | A | |
| | | | | CN | 113677458 | A | |
| JP | 2012-214873 | A | 08 November 2012 | (Family: none) | | | |
| JP | 2017-206763 | A | 24 November 2017 | (Family: none) | | | |
| JP | 2008-255378 | A | 23 October 2008 | WO | 2008/123494 | A1 | |
| | | | | CN | 101626856 | A | |
| | | | | KR | 10-2009-0128380 | A | |
| JP | 2013-189704 | A | 26 September 2013 | US | 2015/0034883 | A1 | |
| | | | | paragraphs [0001]-[0011], [0018]-[0019], [0021], [0030]-[0069], fig. 1-3 | | | |
| | | | | WO | 2013/122244 | A1 | |
| | | | | EP | 2796231 | A1 | |
| | | | | CN | 104136151 | A | |
| | | | | KR | 10-2014-0125418 | A | |
| JP | 2020-56050 | A | 09 April 2020 | US | 2022/0023939 | A1 | |
| | | | | paragraphs [0001]-[0008], [0072]-[0079], [0088]-[0105]-[0131], fig. 1-8 | | | |
| | | | | WO | 2020/067282 | A1 | |
| | | | | CN | 112752627 | A | |
| | | | | KR | 10-2021-0065989 | A | |
| JP | 2011-42839 | A | 03 March 2011 | (Family: none) | | | |
| WO | 2019/117234 | A1 | 20 June 2019 | US | 2021/0162495 | A1 | |
| | | | | entire text, all drawings | | | |
| | | | | EP | 3702064 | A1 | |
| | | | | CN | 111432959 | A | |
| | | | | KR | 10-2020-0096286 | A | |
| WO | 2018/142943 | A1 | 09 August 2018 | US | 2019/0344354 | A1 | |
| | | | | entire text, all drawings | | | |
| | | | | EP | 3578283 | A1 | |
| | | | | CN | 110234452 | A | |
| | | | | KR | 10-2019-0111938 | A | |

Form PCT/ISA/210 (patent family annex) (January 2015)

**EP 4 516 430 A1**